(19) Europäisches Patentamt / European Patent Office / Office européen des brevets

(11) **EP 2 597 490 A1**

(12) **EUROPEAN PATENT APPLICATION**
published in accordance with Art. 153(4) EPC

(43) Date of publication:
**29.05.2013 Bulletin 2013/22**

(51) Int Cl.:
*G01T 3/06* (2006.01)     *C09K 11/00* (2006.01)
*C09K 11/64* (2006.01)     *G01T 1/202* (2006.01)

(21) Application number: **11809676.7**

(22) Date of filing: **20.07.2011**

(86) International application number:
**PCT/JP2011/066486**

(87) International publication number:
**WO 2012/011506 (26.01.2012 Gazette 2012/04)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.07.2010   JP 2010164392**

(71) Applicants:
• **Hiroshima University**
  **Hiroshima 739-8511 (JP)**
• **Tokuyama Corporation**
  **Shunan-shi, Yamaguchi-ken 745-8648 (JP)**
• **Tohoku University**
  **Aoba-ku**
  **Sendai-shi**
  **Miyagi 980-8577 (JP)**

(72) Inventors:
• **TAKAHASHI, Hiromitsu**
  **Higashi-Hiroshima-shi**
  **Hiroshima 739-8511 (JP)**
• **YONETANI, Mitsuo**
  **Higashi-Hiroshima-shi**
  **Hiroshima 739-8511 (JP)**
• **MATSUOKA, Masayuki**
  **Higashi-Hiroshima-shi**
  **Hiroshima 739-8511 (JP)**
• **FUKAZAWA, Yasushi**
  **Higashi-Hiroshima-shi**
  **Hiroshima 739-8511 (JP)**

• **KAWAGUCHI, Noriaki**
  **Shunan-shi**
  **Yamaguchi 745-8648 (JP)**
• **FUKUDA, Kentaro**
  **Shunan-shi**
  **Yamaguchi 745-8648 (JP)**
• **SUYAMA, Toshihisa**
  **Shunan-shi**
  **Yamaguchi 745-8648 (JP)**
• **YOSHIKAWA, Akira**
  **Sendai-shi**
  **Miyagi 980-8577 (JP)**
• **YANAGIDA, Takayuki**
  **Sendai-shi**
  **Miyagi 980-8577 (JP)**
• **YOKOTA, Yui**
  **Sendai-shi**
  **Miyagi 980-8577 (JP)**
• **FUJIMOTO, Yutaka**
  **Sendai-shi**
  **Miyagi 980-8577 (JP)**

(74) Representative: **Jackson, Martin Peter**
  **J A Kemp**
  **14 South Square**
  **Gray's Inn**
  **London WC1R 5JJ (GB)**

(54) **PHOSWICH THERMAL NEUTRON DETECTOR**

(57)     [Problems to be Solved] A phoswich radiation detector, which can easily discriminate between detection signals on gamma rays and thermal neutrons, and which can selectively acquire signals on thermal neutrons, is provided.

[Means to Solve the Problems] In a phoswich radiation detector having two scintillators and discriminating between thermal neutrons and gamma rays, the detector comprises a scintillator for detecting thermal neutrons, such as LiCaAlF$_6$:Eu, which has a light yield of more than 1500 photons/neutron, and a scintillator for detecting gamma rays, which has a permeable end on a shorter wavelength than the light emission wavelength of the thermal neutron scintillator. The scintillator for detecting gamma rays is characterized by being either an organic solid scintillator, such as a plastic scintillator, which does not contain a total amount of 10 mol% or more of elements selected from $^6$Li, $^{10}$B and Gd, or an inorganic single crystal scintillator, such as lithium glass (containing $^6$Li and Ce) or BGO, which has an effective atomic number

EP 2 597 490 A1

$Z_{eff}$ of 30 or larger and which does not contain a total amount of 10 mol% or more of elements selected from $^{6}Li$, $^{10}B$ and Gd.

# Fig. 2

Power Supply Line

Signal Output Line

BGO

$LiCaAlF_6 : Eu$

**Description**

Technical Field:

This invention relates to a phoswich thermal neutron detector equipped with a mechanism for discriminating between gamma rays and thermal neutrons.

Background Art:

Scintillators are substances which, whenhit by radiation such as alpha rays, beta rays, gamma rays, X rays, or neutrons, absorb the radiation to emit light. The scintillator is combined with a photodetector, such as a photomultiplier tube, and this combination is used for detection of radiation.
Radiation detectors have wide varieties of application fields, including medical fields such as tomography, industrial fields such as nondestructive inspection, security fields such as inspection of personal belongings, and academic fields such as high energy physics.
The predominant method of detecting light emission from a scintillator is the photon counting method. The photon counting method is a photometric method with high sensitivity which counts the number of photons by a photodetector to measure the quantity of light. According to this method, an electric signal generatedwhen the photon is received by the photodetector is withdrawn, passed through an amplifier or a shaper, and then counted by a pulse height analyzer. The strength of the electric signal at this time is called a pulse height.
Among scintillators are various types of scintillators according to the type of radiation and the purpose of use. They include inorganic crystals such as a $Bi_4Ge_3O_{12}$ single crystal (will hereinafter be also referred to as BGO) and a Ce-containing $Gd_2SiO_5$ single crystal ($Gd_2SiO_5$:Ce), organic crystals such as anthracene, polymers such as polystyrene or polyvinyltoluene incorporating an organic fluorescent substance, liquid scintillator, and gaseous scintillators.
Of radiations to be detected, neutrons have increased in importance in recent years, particularly, for a purpose such as detection of nuclear matter. In the present invention, a material which emits light when hit by neutrons is called a scintillatorfor detecting neutrons,while amaterial whichemits light in response to gamma rays is called a scintillator for detecting gamma rays.
Neutrons are called variously according to energy, and they are classified into thermal neutrons (about 0.025 eV), epithermal neutrons (about 1 eV), slow neutrons (0.03 to 100 eV), intermediate neutrons (0.1 to 500 keV), and fast neutrons (500 keV or more).
A main object to be detected by neutrons detector is thermal neutrons with low energy. In detecting fast neutrons, a method is adopted in which fast neutrons are slowed down with the use of a moderator, such as polyethylene, to be converted into thermal neutrons, and these neutrons are detected. For example, a rem-counter or a Bonner sphere spectrometer having a thermal neutron detector covered with a spherical polyethylene moderator is used.
Conventional neutrons detection has mainly employed a thermal neutron detector using a $^3$He gas which utilizes a $^3$He (n, p) T reaction between helium 3 ($^3$He) and neutrons. Owing to price hikes of a rare $^3$He gas, however, switching to alternative technologies is desired.
The thermal neutron detector using a solid scintillator, for detecting neutrons is one of promising candidates for the alternative technologies. The predominant solid scintillator for detecting thermal neutrons contains lithium 6 ($^6$Li), and utilizes, for detection, scintillation light produced upon the excitation of a luminescent center within the scintillator by the energy of a particle beam generated by a $^6$Li (n, $\alpha$) $^3$H reaction between $^6$Li and neutrons.
Since the probability of occurrence of the $^6$Li(n, $\alpha$)$^3$H reaction is very low for fast neutrons, the main object to be detected by the thermal neutron detector with the solid scintillator is low energy thermal neutrons, as does the neutrons detector using a $^3$He gas. In order to detect fast neutrons, therefore, the thermal neutron detector with the solid scintillator needs to use a moderator concurrently, like the neutrons detector using a $^3$He gas. The concurrent use of the moderator enables the thermal neutron detector with the solid scintillator to detect neutrons with a wide range of energy, ranging from thermal neutrons to fast neutrons.
As typical properties demanded of a scintillator, a high light yield, high stopping power for radiation, a fast decay time of fluorescence, etc. are named. Particularly in the scintillator for detecting thermal neutrons, whose object of detection is thermal neutrons, a radiative capture reaction occurs between the neutrons and the absorbent material, so that gamma rays are prone to occur in the measuring environment. The scintillator for detecting neutrons is excited by both of these gamma rays and thermal neutrons to emit light. Aneutrondetector using the scintillator, therefore, needs to have the function of selectively acquiring signals of light emission on gamma rays and thermal neutrons, namely, the abilityto discriminate between gamma rays and thermal neutrons.
The light yield in the present invention refers to a value obtained by dividing the total number of photons, in single light emission by the scintillator upon excitation by radiation, by the energy of radiation from an excitation source. Its units are, for example, photons/MeV for excitation by gamma rays or alpha rays, and photons/neutron for excitation by neutrons.

One of methods for discriminating between gamma rays and thermal neutrons is the pulse height discrimination method. In the measuring environment where gamma rays and thermal neutrons are both existent, when the pulse height of a detection signal upon thermal neutron excitation is greater than the pulse height of a detection signal upon gamma ray excitation, a threshold value is set for the pulse height to eliminate signals having a small pulse height. By so doing, the influence of gamma rays can be reduced.

However, energy produced from a nuclear reaction for detection of thermal neutrons, which is ascribed to $^{6}Li$ (n, $\alpha$) $^{3}H$ reaction [$^{6}Li+n\rightarrow\alpha+^{3}H+4.8$ MeV], is constant, whereas the energy of gamma rays may be markedly high depending on the measuring environment. No matter what solid scintillator is used, therefore, there can be a case where the pulse height of a detection signal upon gamma ray excitation is higher than the pulse height of a detection signal upon thermal neutron excitation. Thus, a common challenge facing solid scintillators is how to eliminate detection signals for gamma rays and take out only detection signals for thermal neutrons.

On the other hand, there exists a technology called a phoswich detector which comprises a combination of two or more types of scintillators and discriminates the types of irradiated radiations based on the difference between the decay times of light emissions from the respective scintillators. The phoswich detector is closely studied particularly in Japan, and is used, for example, for discrimination between alpha rays or beta rays and fast neutrons.

There have been few examples of investigations into phoswich detectors intended for detecting thermal neutrons. Patent Document 1, however, reports a phoswich detector which discriminates between alpha rays or beta rays and thermal neutrons with the use of an optical filter.

The inventors of the present invention proposed a new phoswich detector comprising a Ce-containing $LiYF_4$ single crystal (also referred to as $LiYF_4$:Ce) and BGO, the detector adapted to discriminate between thermal neutrons and gamma rays (Non-Patent Document 1). Non-Patent Document 1 also describes the possibility of achieving a phoswich detector having a Ce-containing $LiCaAlF_6$ single crystal (also referred to as $LiCaAlF_6$:Ce) as a scintillator for detecting thermal neutrons, and also having BGO as a scintillator for detecting gamma rays, although the document shows no experimental examples concerned with such a phoswich detector.

Prior Art Documents:

Patent Documents:

Patent Document 1: JP-A-6-123777

Non-Patent Documents:

Non-Patent Document 1: H. Takahashi, M. Matsuoka, T. Mizuno, Y. Fukazawa, T. Yanagida, Y. Yokota, A. Yoshikawa, N. Kawaguchi, S. Ishizu, K. Fukuda, "Study on a Phoswich Detector Consisting of Li-Composed Crystal Scintillator and BGO for Neutron Measurement.", IEEE NSS MIC 2009, CR 2105-21071 (2009)

Summary of the Invention:

Problems to be solved by the invention:

Non-Patent Document 1 predicts the possibility of discrimination between thermal neutrons and gamma rays in the light of the results of a discrimination test on alpha rays and gamma rays when $LiYF_4$:Ce is used. However, a study, actually conducted by the present inventors, of the phoswich detector for discriminating between thermal neutrons and gamma rays obtained the following results: Compared with the energy 5.49 MeV of alpha rays from $^{241}Am$ used in excitation, excitation energy obtained by a nuclear reaction between thermal neutrons and $^{6}Li$ was low (4.8 MeV), and light emission obtained upon irradiation with thermal neutrons was found to be insufficient for detection of thermal neutron. The reasons were as follows: When a photomultiplier tube is used as a photodetector, a detection signal showing a pulse height enough great to be sufficiently separable from a thermionic noise (a signal due to a background dark current always occurring even when light emission is not detected) of the photomultiplier tube cannot be obtained, since light emission intensity is not sufficient.

Non-Patent Document 1 also predicted that a phoswich detector having $LiCaAlF_6$:Ce as a scintillator for detecting thermal neutrons and also having BGO as a scintillator for detecting gamma rays could be achieved. However, this is erroneous, and the combination of $LiCaAlF_6$:Ce and BGO has been found not to act as a phoswich detector, contrary to the expectation.

The investigations, in which irradiations with thermal neutrons and gamma rays were actually performed, encountered the problems difficult to anticipate from the publicly known technologies, as discussed above. Patent Document 1 on the phoswich detector targeted for detection of thermal neutrons, which is a conventional technology, investigates the phoswich detector using an optical filter, and studies discrimination between alpha rays and thermal neutrons. However, this document is not designed to discriminate between gamma rays and thermal neutrons. Nor does it carry out the investigation of such discrimination.

After all, the problems encountered in realizing a phoswich detector, which discriminates between thermal neutrons and gamma rays, have not been manifested in the publicly known conventional technologies, and remain unsolved. Thus, there has been the necessity of developing the constitution of a phoswich detector which is suitable for solving the problems newly and discriminating between thermal neutrons and gamma rays.

The present invention has been accomplished in the light of the problems mentioned above. It is an obj ect of the invention to provide a thermal neutron detector for discriminating between detection signals on gamma rays and thermal neutrons, and selectively acquiring signals derived from thermal neutrons.

Means for solving the problems:

The present inventors conducted diligent studies on phoswich detectors capable of discriminating between gamma rays and thermal neutrons with high efficiency in an attempt to develop a thermal neutron detector minimally influenced by gamma rays. As a result, they have obtained the following three findings, and completed the present invention:

(1) When the light yield of a thermal neutron scintillator exceeds 1500 photons/neutron, even a general-purpose photomultiplier tube with a quantum efficiency of about 25% gives a detection peak of thermal neutrons at pulse heights nearly free from influence by thermionic noises in light emission wavelengths.

(2) When a permeable end of light from a gamma ray detection scintillator is of a shorter wavelength than the light emission wavelength of the thermal neutron scintillator, detection signals on thermal neutrons are obtained.

(3) The use of an inorganic single crystal scintillator, which has an effective atomic number $Z_{eff}$ of 30 or larger and which does not contain a total amount of 10 mol% or more of elements selected from lithium 6 ($^6$Li) , boron 10 ($^{10}$B) and gadolinium (Gd), makes gamma rays easily absorbable, and facilitates discrimination between thermal neutrons and gamma rays. On the other hand, the use of an organic solid scintillator, which does not contain a total amount of 10 mol% or more of elements selected from $^6$Li, $^{10}$B and Gd, can provide a sufficient size at a low cost, in comparison with the inorganic single crystal scintillator.

Thus, the organic solid scintillator can increase gamma ray absorptivity owing to the effect of thickness, even if its gamma ray absorption efficiency is low, and enables gamma rays to be discriminated easily.

That is, according to the present invention, there is provided a phoswich radiation detector having two scintillators and discriminating between thermal neutrons and gamma rays, the phoswich radiation detector comprising a scintillator for detecting thermal neutrons, which has a light yield of more than 1500 photons/neutron, and a scintillator for detecting gamma rays, which has a permeable end on a shorter wavelength than the light emission wavelength of the thermal neutron scintillator, wherein the scintillator for detecting gamma rays is either an organic solid scintillator which does not contain 10 mol% or more of elements selected from $^6$Li, $^{10}$B and Gd, or an inorganic single crystal scintillator which has an effective atomic number $Z_{eff}$ of 30 or larger and which does not contain 10 mol% or more of elements selected from $^6$Li, $^{10}$B and Gd.

In the invention of the above phoswich radiation detector, it is preferred that

1) the scintillator for detecting thermal neutrons be a Eu-containing $LiABF_6$ crystal (where A represents at least one element selected from Ca, Sr, Ba, Mg, Mn, Ni, Zn and Cd, and B represents at least one element selected from Al, Ga, Cr, Co, Fe, Ti and V);

2) the scintillator for detecting gamma rays be an inorganic single crystal scintillator which has an effective atomic number $Z_{eff}$ of 30 or larger and which does not contain 10 mol% or more of elements selected from $^6$Li, $^{10}$B and Gd;

3) the scintillator for detecting thermal neutrons be structured to be sandwiched between the scintillators for detecting gamma rays; and

4) the scintillator for detecting thermal neutrons be structured to have all of its periphery covered with the scintillators for detecting gamma rays.

Effects of the invention:

According to the present invention, a phoswich radiation detector with two types of scintillators is realized which can easily discriminate between thermal neutrons and gamma rays and which can obtain a detection peak of thermal neutrons at pulse heights minimally influenced by thermionic noises. This detector can be used preferably in industrial fields such as nondestructive inspection, security fields such as inspection of personal belongings, and academic fields such as high energy physics.

Brief Description of the Drawings:

[Fig. 1] is a schematic sectional view of a phoswich detector according to the present invention.
[Fig. 2] is a schematic sectional view of a phoswich detector according to an embodiment of the present invention.
[Fig. 3] is a view showing the light emission waveforms of $LiCaAlF_6$:Eu and BGO.
[Fig. 4] is a view of pulse height spectra obtained when gamma ray signals were selectively eliminated and when they were not eliminated.

Mode for Carrying Out the Invention:

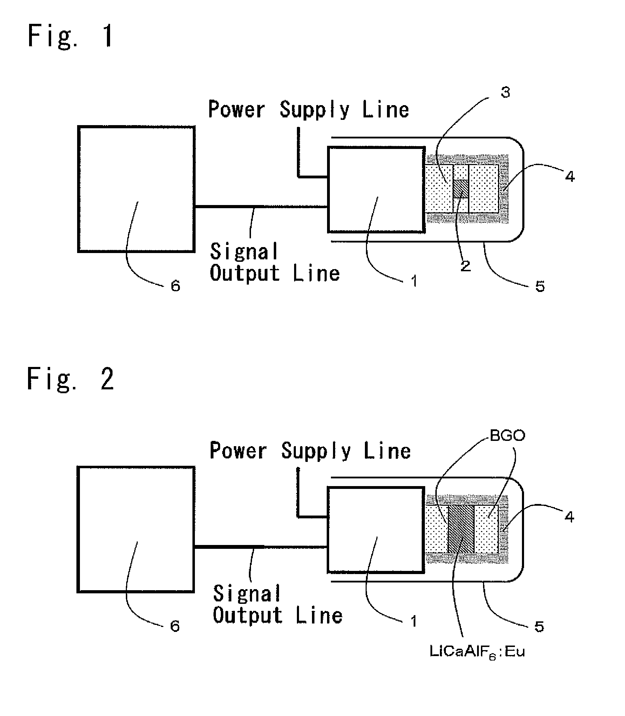

The phoswich detector of the present invention, which discriminates between gamma rays and thermal neutrons, is mainly constituted by a photodetector 1, a scintillator 2 for detecting thermal neutrons, and a scintillator 3 for detecting gamma rays, as shown in Fig. 1. Preferably, a part or all of the periphery of the scintillator 2 for detecting thermal neutrons is covered with the scintillators 3 for detecting gamma rays. Around the scintillators 3 for detecting gamma rays, it is preferred to form a reflector 4 and a light shielding material 5.
Electrical signals obtained from the photodetector 1 are inputted to an electrical signal analyzing unit 6 to analyze signal waveforms based on the decay times of the scintillator for detecting thermal neutrons and the scintillator for detecting gamma rays and discriminate between signals on thermal neutrons and those on gamma rays. By grasping the statistical distributions of the pulse heights of the signals, moreover, pulse height spectra can be obtained.
As the photodetector 1, a photodetector such as a photomultiplier tube or a silicon photodiode, which has been known publicly, can be used preferably. In the case of the photomultiplier tube, R7899, R6231, and H7416 produced by HAMAMATSU PHOTONICS K. K. , for example, can be used preferably. The quantum efficiency of a typical photomultiplier tube for visible light, which is used generally and widely, is of the order of about 25% at a wavelength of about 400 nm.
The scintillator 2 for detecting thermal neutrons is a scintillator for detecting thermal neutrons which has a light yield of more than 1500 photons/neutron. Its typical examples are lithium glass (containing $^6$Li and Ce), a lithium glass fiber (containing $^6$Li and Ce), a Eu-containing lithium iodide single crystal (LiI:Eu), a $^6$Li-containing elpasolite compound ($Cs_2LiYCl_6$:Ce, $Cs_2LiYBr_6$:Ce, $Cs_2LiYI_6$:Ce, etc.), and a Eu-containing $LiCaAlF_6$ single crystal ($LiCaAlF_6$:Eu).
The scintillator for detecting thermal neutrons to be used has to be selected in consideration of its combination with the scintillator for detecting gamma rays, and its details will be described later.
The reasons why the scintillator for detecting thermal neutrons needs to have a light yield of more than 1500 photons/neutron are as follows:
If the light yield is equal to or less than 1500 photons/neutron, when light emitted upon irradiation with thermal neutrons is received by the photomultiplier tube, the most sensitive photodetector, the pulse heights ascribed to the light emission from the scintillator are so low that they are comparable to the pulse heights of thermionic noises derived from the photomultiplier tube, and cannot be fully separated from the latter pulse heights. Normally, thermionic noises have small pulse heights, and are thus removed by setting a threshold value for the pulse height. If the pulse heights of light emission from the scintillator for detecting thermal neutrons are smaller than the pulse heights of the thermionic noises, however, emitted light is removed during removal of the thermionic noises, worsening the efficiency of measurement.
The size of the scintillator 2 for detecting thermal neutrons is not limited, but the area of the scintillator is rendered smaller than the plane of incidence of light which the photodetector 1 has. By so doing, light emitted from the scintillator can be made incident on the photodetector without being wasted.
The thickness in a direction in which thermal neutrons are assumed to be incident is preferably determined by the probability of occurrence of a nuclear reaction with thermal neutrons. In the case of $LiCaAlF_6$ with $^6$Li concentrated to 95%, for example, the absorption cross section of $^6$Li for 0.025 eV thermal neutrons is 940 barns. Thus, it is calculated that a nuclear reaction will occur with about 80% of thermal neutrons at a thickness of 2 mm and about 95% of thermal neutrons at a thickness of 4 mm. Hence, there should preferably be a thickness of about 4 mm or more in order to detect 90% or more of thermal neutrons.

The following facts were found out during the process of investigations for accomplishing the present invention: When the light emission wavelength of the scintillator 2 for detecting thermal neutrons is shorter than the wavelength of the permeable end of the scintillator 3 for detecting gamma rays, light emission upon irradiation with thermal neutrons attenuates before reaching the photodetector. Thus, detection signals on thermal neutrons are not obtained, so that the detector with these scintillators does not act as a phoswich detector.

Thus, the scintillator 3 for detecting gamma rays needs to have a permeable end on a shorter wavelength than the light emission wavelength of the scintillator for detecting thermal neutrons. For example, a combination of $LiCaAlF_6$: Pr with a light emission wavelength of 260 nm and BGO with a permeable end wavelength of 300 nm cannot be used in the present invention. When the transmission spectrum of light through a material is measured, a short wavelength undergoes absorption, and the material is not permeable to the light. A limiting wavelength at which the material is permeable to the light is a permeable end.

Furthermore, the scintillator for detecting gamma rays is either an organic solid scintillator which does not contain a total amount of 10 mol% or more of elements selected from $^6Li$, $^{10}B$ and Gd, or an inorganic single crystal scintillator which has an effective atomic number $Z_{eff}$ of 30 or larger and which does not contain a total amount of 10 mol% or more of elements selected from $^6Li$, $^{10}B$ and Gd.

Specific examples of the former organic solid scintillator are plastic scintillators having organic fluorescent materials incorporated into transparent plastic matrixes such as polyvinyltoluene, polymethyl methacrylate, and polystyrene. As the plastic scintillators, commercially available products such as the BC400 Series produced by Saint-Gobain Crystals, and NE102A produced by NE Technology.

Examples of the latter inorganic single crystal scintillator are BGO, a Tl-containing sodium iodide single crystal (NaI:Tl), a cesium iodide single crystal (CsI), a Ce-containing $Lu_2SiO_5$ single crystal ($Lu_2SiO_5$:Ce), a Ce-containing $Lu_{1.8}Y_{0.2}SiO_5$ single crystal ($Lu_{1.8}Y_{0.2}SiO_5$:Ce), a Ce-containing lanthanum bromide single crystal (LaBr:Ce), and a cerium fluoride single crystal ($CeF_3$).

The reason why the contents of $^6Li$, $^{10}B$ and Gd are restricted is that these elements cause a nuclear reaction with thermal neutrons to emit light. If $^6Li$, $^{10}B$ and Gd are contained in a total amount of 10 mol% or more in the scintillator for detecting gamma rays, light may be emitted even responsive to thermal neutrons as well as gamma rays. This tends tomake discrimination between gamma rays and thermal neutrons difficult. Preferably, these elements are not contained in amounts exceeding those inevitably included as impurities during the manufacture of the scintillator; that is, they are not substantially contained.

When the scintillator 3 for detecting gamma rays is the organic solid scintillator such as a plastic scintillator, the scintillator of a large size can be prepared inexpensively, unlike the inorganic single crystal scintillator. Thus, a thickness capable of sufficiently inhibiting gamma rays can be easily obtained.

With the inorganic single crystal scintillator, it is difficult to prepare a large scintillator at a low cost, because of difficulty in growing a single crystal, as compared with the organic solid scintillator. Hence, the scintillator needs to be a material which can sufficiently absorb gamma rays, even when its thickness is small. Concretely, an inorganic single crystal having an effective atomic number $Z_{eff}$ of 30 or larger is preferred.

In the present invention, the effective atomic number refers to an indicator defined by Equation [1] shown below. The larger the effective atomic number, the more easily the interaction between the material and gamma rays, called photoelectric absorption, takes place. Lightemissionobtained when photoelectric absorption occurs is used in the detection of gamma rays.

According to studies by the present inventors, the inorganic single crystal having $Z_{eff}$ of 30 or larger causes photoelectric absorption relatively easily, and can be used preferably for detection of gamma rays.

$$\texttt{Effective atomic number } Z_{eff} = (\Sigma W_i Z_i^4)^{1/4} \quad [1]$$

where $W_i$ and $Z_i$ represent, respectively, the mass fraction and the atomic number of the $i$-th element of the elements constituting the scintillator.

Cadmium (Cd), samarium (Sm) and europium (Eu) are elements with large thermal neutron capture cross sections. Thus, if these elements are contained as the constituent elements of the matrix crystal of the scintillator for detecting gamma rays, thermal neutrons are absorbed to the scintillator for detecting gamma rays present outside the scintillator for detecting thermal neutrons before these neutrons reach the scintillator for detecting thermal neutrons, with the result that the number of the thermal neutrons is markedly decreased. Hence, it is preferred for these three elements not tobe contained in a total amount of 10 mol% or more as the elements constituting the matrix crystal.

Upon the principle of the phoswich detector, moreover, the scintillator for detecting thermal neutrons and the scintillator for detecting gamma rays are incapable of discrimination, unless their decay times are different. Thus, the materials need to be selected such that their decay times are different.

It is preferred if their decay times are different by almost an order of magnitude or more, because discrimination will be easier. Concrete examples are a combination of several tens of nanoseconds and several hundred nanoseconds, a combination of several tens of nanoseconds and several microseconds, and a combination of several hundred nanoseconds and several microseconds. It is important that the decay times of both scintillators be different, and it does not matter which of the decay times is the longer. Here, it is necessary to select a combination which fulfills the requirement that the scintillator for detecting gamma rays has a permeable end on a shorter wavelength than the light emission wavelength of the scintillator for detecting thermal neutrons, as stated earlier.

There are no limitations on the structures of the scintillator 2 for detecting thermal neutrons and the scintillator 3 for detecting gamma rays. However, gamma rays should be intensively reacted with the scintillator 3 for detecting gamma rays to emit light, while only thermal neutrons should be intensively reacted with the scintillator 2 for detecting thermal neutrons to emit light. For this purpose, the preferred structure is one in which the scintillator 2 for detecting thermal neutrons is sandwiched between the scintillators 3 for detecting gamma rays, as shown in Fig. 2. From this point of view, a structure in which all the periphery of the scintillator 2 for detecting thermal neutrons is covered with the scintillators 3 for detecting gamma rays, as shown in Fig. 1, is the most preferred structure.

As the reflector 4, polytetrafluoroethylene and barium sulfate, for example, can be used preferably. Preferably usable as the light shielding material 5 are materials which do not allow passage of visible light, such as commercially available light shielding sheets and an aluminum foil.

As the electrical signal analyzing unit 6, a readout circuit of a publicly known phoswich detector can be used. Use is made of a circuit having the functions of acquiring signals from the photodetector 1 and discriminating between the decay time constants of light emissions. From the resulting signals, the statistical distributions of the pulse heights are grasped, whereby pulse height spectra can be drawn.

The detector of the present invention, achieved as described above, can be constituted as a detector which detects thermal neutrons and gamma rays, selectively separates their respective detection signals, and thereby detects thermal neutrons and gamma rays discriminatively. By using the detector of the present invention, it becomes possible to eliminate detection signals on gamma rays and detect only thermal neutrons, or eliminate detection signals on thermal neutrons and detect gamma rays, or detect both of thermal neutrons and gamma rays at the same time in a separated manner.

Examples:

Hereinbelow, the present invention will be described concretely by reference to its Examples, but the present invention is in no way limited by these Examples. Moreover, not all of combinations of the features described in the Examples are essential to the means for solution to the problems that the present invention adopts.

Example 1

For the scintillators of the phoswich detector according to the present invention, $LiCaAlF_6$: Eu was used as the scintillator for detecting thermal neutrons, and BGO was used as the scintillator for detecting gamma rays.

It is sufficient for the $LiCaAlF_6$: Eu to have a light yield of about 20,000 photons/neutron, which is about 3 times that of lithium glass, and its light emission wavelength is 370 nm. The permeable end of the BGO is 300 nm, which is a shorter wavelength than the light emission wavelength of the $LiCaAlF_6$: Eu. The BGO is an inorganic single crystal scintillator having an effective atomic number of 74.

The $LiCaAlF_6$:Eu single crystal was prepared using a crystal preparation apparatus by the Czochralski method. High purity fluoride powders of 95% $^6LiF$, $CaF_2$, $AlF_3$ and $EuF_3$, each having purity of 99.99% or higher, were used as raw materials. A crucible, a heater, and a heat insulator used were formed of high purity carbon.

First, 269.7 g of 95% $^6LiF$, 784.0 g of $CaF_2$, 903.5 g of $AlF_3$ and 42.8 g of $EuF_3$ were weighed, and mixed thoroughly. The resulting material mixture was charged into the crucible. The crucible charged with the materials was installed on a movable stage, whereafter the heater and the heat insulator were sequentially installed around the crucible. Then, a $LiCaAlF_6$ single crystal, which had been cut, ground and polished in the form of a rectangular parallelepiped measuring $6 \times 6 \times 30$ mm$^3$, with the 30 mm side extending along the c-axis direction, was used as a seed crystal, and mounted on the front end of an automatic diameter control device. Then, the interior of a chamber was evacuated under vacuum to $5.0 \times 10^{-4}$ Pa by use of a vacuum evacuation device composed of an oil-sealed rotary vacuum pump and an oil diffusion pump. Then, a tetrafluoromethane-argon mixed gas was introduced into the chamber up to atmospheric pressure for gas exchange.

A high frequency current was applied to a high frequency coil to heat the materials by induction heating, thereby melting them. The seed crystal was moved and brought into contact with the liquid surface of the molten material melt. The output of the heater was adjusted such that a portion of the melt in contact with the seed crystal reached a solidification temperature. Then, under control by the automatic diameter control device, the resulting crystal was pulled upward, with the pull rate being automatically adjusted so as to achieve a diameter of 55 mm.

During crystal growth, the movable stage was moved, as appropriate, in order to adjust the liquid level to a constant position, and the crystal was continuously pulled up, with the output of the high frequency coil being adjusted where appropriate. When the crystal grew to a length of about 70 mm, the crystal was cut off the liquid surface, and cooled over about 48 hours to obtain a Eu-containing $LiCaAlF_6$ crystal with a diameter of 55 mm and a length of about 70 mm.

The BGO used was a commercially available one produced by Saint-Gobain Crystals. The photomultiplier tube used was R7899 produced by HAMAMATSU PHOTONICS K.K. The electrical signal analyzing unit used was the same as that of Non-Patent Document 1.

The scintillator for detecting thermal neutrons and the scintillator for detecting gamma rays, mentioned above, were used to produce a phoswich detector of the structure shown in Fig. 2. The $LiCaAlF_6$: Eu and the two BGOs were each processed into the shape of a hexagonal prism having a thickness of 10 mm and having a hexagonal plane with each side measuring 15 mm, and the $LiCaAlF_6$: Eu was sandwiched between the two BGOs. The scintillators were bonded together, and the scintillator and the photomultiplier tube were bonded together, using an optical grease produced by OHYO KOKEN KOGYO CO., LTD.

The above-described radiation detector was irradiated with gamma rays and thermal neutrons. A source of the gamma rays used was $^{137}Cs$ and a source of the thermal neutrons used was $^{252}Cf$, each of the $^{137}Cs$ and the $^{252}Cf$ being placed in a 40 mm polyethylene container.

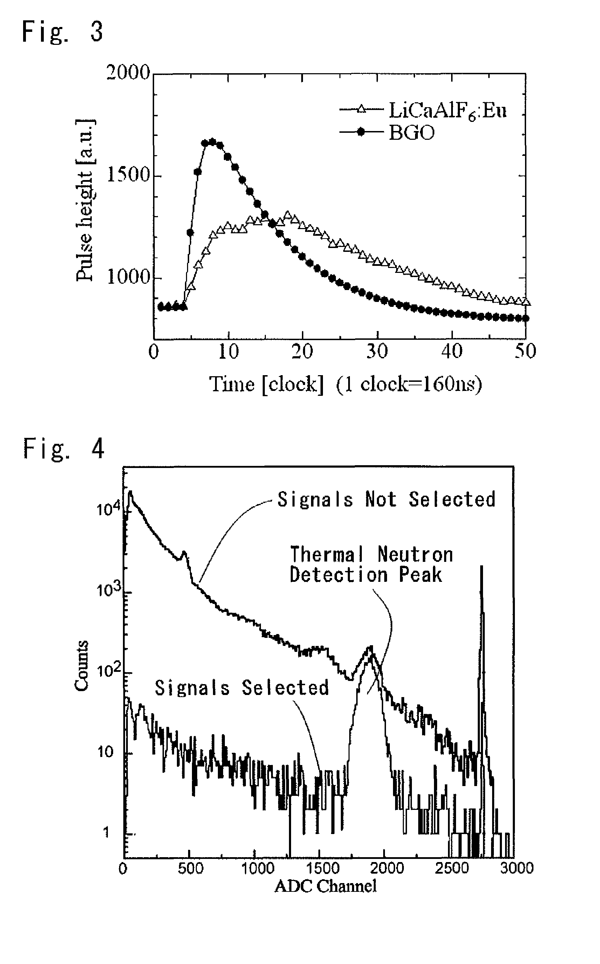

Signals obtained from the $LiCaAlF_6$:Eu and the BGO are plotted in Fig. 3 in which the ordinate represents the strength and the abscissa represents time. The unit for the horizontal axis was clocks (1 clock = 160 nanoseconds). A solid line connecting open triangles "$\Delta$" represents a thermal neutron-associated spectrum obtained from the $LiCaAlF_6$:Eu, while a solid line connecting filled circles "●" represents a gamma ray-associated spectrum obtained from the BGO. Clearly, the resulting waveforms were different in decay time.

As clearly recognizable from Fig. 3, when A value = pulse height (pulse height at 10 clocks) was compared with B value = pulse height (pulse height at 20 clocks), the thermal neutron-associated spectrum obtained from the $LiCaAlF_6$:Eu showed little difference between both values. In the gamma ray-associated spectrum obtained from the BGO, the A value was at least twice as high as the B value. Hence, signals with the A value exceeding 1. 5 times the B value were processed as gamma ray signals derived from the BGO.

The resulting BGO-derived signals were selectively eliminated as gamma ray signals from the resulting energy spectrum. Pulse height spectra obtained upon selective signal elimination and without selective signal elimination are shown in Fig. 4. It is seen from Fig. 4 that a detection peak of thermal neutrons canbe clearly separated, and that the phoswich detector constituted in the above-described manner has been able to discriminate between thermal neutrons and gamma rays.

Explanations of Letters or Numerals:

1    Photodetector
2    Scintillator for detecting thermal neutrons
3    Scintillator for detecting gamma rays
4    Reflector
5    Light shielding material
6    Electrical signal analyzing unit

**Claims**

1. A phoswich radiation detector having two scintillators and discriminating between thermal neutrons and gamma rays, the phoswich radiation detector comprising:

   a scintillator for detecting thermal neutrons, which has a light yield of more than 1500 photons/neutron; and
   a scintillator for detecting gamma rays, which has a permeable end on a shorter wavelength than a light emission wavelength of the thermal neutron scintillator,
   wherein the scintillator for detecting gamma rays is either an organic solid scintillator which does not contain 10 mol% or more of elements selected from $^6Li$, $^{10}B$ and Gd, or an inorganic single crystal scintillator which has an effective atomic number $Z_{eff}$ of 30 or larger and which does not contain 10 mol% or more of elements selected from $^6Li$, $^{10}B$ and Gd.

2. The phoswich radiation detector according to claim 1, wherein the scintillator for detecting thermal neutrons is a Eu-containing LiABF$_6$ single crystal (where A represents at least one element selected from Ca, Sr, Ba, Mg, Mn, Ni, Zn and Cd, and B represents at least one element selected from Al, Ga, Cr, Co, Fe, Ti and V).

3. The phoswich radiation detector according to claim 1, wherein the scintillator for detecting gamma rays is an inorganic single crystal scintillator which has an effective atomic number Z$_{eff}$ of 30 or larger and which does not contain 10 mol% or more of elements selected from $^6$Li, $^{10}$B and Gd.

4. The phoswich radiation detector according to claim 1, wherein the scintillator for detecting thermal neutrons is structured to have a part or all of a periphery thereof covered with the scintillators for detecting gamma rays.

Fig. 1

Power Supply Line

Signal
Output Line

6

3

4

2

5

1

Fig. 2

Power Supply Line

BGO

Signal
Output Line

6

4

5

1

LiCaAlF$_6$:Eu

Fig. 3

Fig. 4

## INTERNATIONAL SEARCH REPORT

| | International application No. |
|---|---|
| | PCT/JP2011/066486 |

### A. CLASSIFICATION OF SUBJECT MATTER
*G01T3/06*(2006.01)i, *C09K11/00*(2006.01)i, *C09K11/64*(2006.01)i, *G01T1/202*
(2006.01)i

According to International Patent Classification (IPC) or to both national classification and IPC

### B. FIELDS SEARCHED

Minimum documentation searched (classification system followed by classification symbols)
G01T3/06, C09K11/00, C09K11/64, G01T1/202

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 11-271453 A (Toshiba Corp.),<br>08 October 1999 (08.10.1999),<br>entire text; all drawings<br>& US 6313465 B1 & EP 947855 A2<br>& DE 69928465 D & DE 69928465 T | 1,3-4<br>2 |
| Y | WO 2009/119378 A1 (Tokuyama Corp.),<br>01 October 2009 (01.10.2009),<br>paragraphs [0029] to [0031]<br>& US 2010/0314550 A1 & EP 2256177 A1<br>& CA 2717341 A & CN 101945974 A<br>& KR 10-2010-0125326 A | 2 |
| Y | WO 2004/086089 A1 (Hokushin Corp.),<br>07 October 2004 (07.10.2004),<br>entire text; all drawings<br>& US 2006/0033025 A1 | 2 |

☐ Further documents are listed in the continuation of Box C. ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 05 October, 2011 (05.10.11) | 18 October, 2011 (18.10.11) |

| Name and mailing address of the ISA/<br>Japanese Patent Office | Authorized officer |
|---|---|
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 6123777 A

**Non-patent literature cited in the description**

• **H. TAKAHASHI ; M. MATSUOKA ; T. MIZUNO ; Y. FUKAZAWA ; T. YANAGIDA ; Y. YOKOTA ; A. YOSHIKAWA ; N. KAWAGUCHI ; S. ISHIZU ; K. FUKUDA.** Study on a Phoswich Detector Consisting of Li-Composed Crystal Scintillator and BGO for Neutron Measurement. *IEEE NSS MIC 2009,* 2009, 2105-21071